# EUROPÄISCHE PATENTSCHRIFT

(11) **EP 0 551 616 B1**
(45) Veröffentlichungstag und Bekanntmachung des Hinweises auf die Patenterteilung: **28.08.1996**
(21) Anmeldenummer: 92121062.1
(22) Anmeldetag: 10.12.1992
(51) Int. Cl.: G01P 15/08, E04B 9/36, E04B 9/06

(54) **Verfahren zum Vereinzeln von als Differentialkondensatoren ausgebildeten Beschleunigungssensoren**
Method for dicing differential capacitor accelerometers
Procédé de découpage d'accéléromètres à condensateurs différentiels

(30) Priorität: 17.01.1992 DE 4201104
(43) Veröffentlichungstag der Anmeldung: 21.07.1993
(73) Patentinhaber: VDO Adolf Schindling AG, D-60326 Frankfurt/Main (DE)
(72) Erfinder: Plankenhorn, Horst, Dipl.-Ing. (FH), W-7730 Villingen-Schwenningen (DE)

(56) Entgegenhaltungen:
- SENSORS AND ACTUATORS - A PHYSICAL, A21-A23 Bd. A21, Nr. 1/3, 1. Februar 1990, LAUSANNE, CH Seiten 297 - 302 , XP000246778 F.RUDOLF ET AL 'PRECISION ACCELEROMETERS WITH G RESOLUTION'
- PATENT ABSTRACTS OF JAPAN vol. 15, no. 229 (E-1076)11. Juni 1991 & JP-A-30 66 176 (MITSUBISHI ELECTRIC CORP.)

## Beschreibung

### Verfahren zum Vereinzeln von als Differentialkondensatoren ausgebildeten Beschleunigungssensoren

Die Erfindung betrifft ein Verfahren zum Vereinzeln von als Differentialkondensatoren ausgebildeten Beschleunigungssensoren aus einem Glas-Silizium-Glas-Schichtpaket, bei welchem die scheibenförmige Siliziumschicht eine Gitterstruktur mit freigesparten Biegeschwingern aufweist und die mit der Siliziumscheibe verbondeten Glasscheiben den plattenförmigen Massen der Biegeschwinger zugewandte, im wesentlichen flächengleiche Metallschichten tragen, welche mit auf einer Glasscheibe aufgebrachten Anschlußkontakten elektrisch leitend verbunden sind.

Ein derartiger Schichtaufbau zur mikromechanischen Fertigung kapazitiver Beschleunigungssensoren, und zwar zur gleichzeitigen Fertigung einer Vielzahl von Sensoren gemäß der Druckschrift Sensors and Actuators, 1990, Seiten 297-302, ist mit einem Minimum an gut reproduzierbaren Prozeßschritten herstellbar, d. h. an einer p- oder n-leitend dotierten Siliziumscheibe werden in an sich bekannter Weise durch mehrfache Anwendung photolithografischer Strukturtechnik und anisotropen Ätzens die für die Funktion der Beschleunigungssensierung erforderlichen, elastisch beweglichen Massen freigespart und Ausnehmungen zur elektrischen Isolation von Leiterbahnen und zur Freistellung von Anschlußkontakten angebracht. Die zwangsweise plattenförmig ausgebildeten Massen der auf diese Weise gebildeten Biegeschwinger wirken aufgrund der Leitfähigkeit der dotierten Siliziumscheibe ohne zusätzliche Maßnahmen als bewegliche Kondensatorelektroden. Die zugeordneten Gegenelektroden werden zusammen mit geeigneten Leiterbahnen auf Pyrex-Glasscheiben aufgedampft bzw. aus metallbedampften Pyrex-Glasflächen photolithografisch herausstrukturiert. Danach erfolgt die Verbindung des Glas-Silizium-Glas-Schichtpaketes durch anodisches Bonden.

Dieser für die Herstellung des Schichtpaketes vorteilhafte Aufbau zeigt beim Vereinzeln der Beschleunigungssensoren einen erheblichen Nachteil, und zwar deshalb, weil bei der vorgesehenen, möglichst einfachen Gestaltung auf eine Evakuierung der Räume, in denen die Biegeschwinger ausgebildet sind, verzichtet wurde und die die Gegenelektroden mit außenliegenden Anschlußkontakten verbindenden Leiterbahnen durch geeignete Aussparungen in der Siliziumscheibe herausgeführt sind, d. h. die vereinzelten Sensoren nicht hermetisch dicht sind. Andererseits muß aber auch das Vereinzeln prozeßgerecht, beispielsweise mittels numerisch gesteuerter Diamanttrennscheiben erfolgen. Dabei besteht die Gefahr, daß Kühl- bzw. Schmierflüssigkeit, insbesondere aber Schleifstaub in die relativ engen, im 100stel mm-Bereich liegenden Spalten zwischen den beweglichen Massen der Biegeschwinger und den Gegenelektroden gelangen und die Biegeschwinger entweder mechanisch blockieren oder Kurzschlüsse verursachen.

Es war somit die Aufgabe gestellt, bei dem angestrebten, prozeßgerechten Vereinzeln der Beschleunigungssensoren Verschmutzungen der geschilderten Art zu vermeiden und bei möglichst einfacher Sensorarchitektur mit dem Vereinzeln eine genau definierte und reproduzierbare Freistellung und Zugänglichkeit der Anschlußkontakte zu erzielen.

Die Lösung der Aufgabe sieht vor, daß das Glas-Silizium-Glas-Schichtpaket kreuzweise eingeschnitten wird, wobei zum Freilegen der Anschlußkontakte das Einschneiden wenigstens in der einen Richtung gegenseitig und in zwei parallelen Ebenen erfolgt und zwischen den als Auflage für die Glasscheiben dienenden Stegen der gitterförmigen Siliziumscheibe und der Anschlußkontakte tragenden Glasscheibe vor dem Bonden wenigstens in einem Randbereich zwischen der äußeren Schnittebene zum Freilegen der Anschlußkontakte eines Beschleunigungssensors und den Anschlußkontakten eine eine Bondverbindung verhindernde Zwischenschicht eingerichtet wird und daß das Schichtpaket an den durch Einschneiden geschaffenen Sollbruchstellen gebrochen wird.

Weitere vorteilhafte Ausbildungen der Erfindung beschreiben die abhängigen Ansprüche.

Die gefundene Lösung bietet den Vorteil, daß die Beschleunigungssensoren erst im Augenblick des Brechens nicht mehr hermetisch geschlossen sind und somit der beim Einschneiden entstehende Schleifstaub sowie Kühlmittelreste zuvor ohne besonderen Aufwand beseitigt werden können. Außerdem wird, ohne daß zusätzlicher Fertigungsaufwand entsteht, mit dem parallel versetzten Einschneiden in Verbindung mit der das anodische Bonden verhindernden Zwischenschicht, die gleichzeitig mit den Gegenelektroden aufgebracht wird, einerseits ein genau definiertes Brechen der Siliziumscheibe erzielt, andererseits werden die Anschlußkontakte ohne umgebende Siliziumreste auf einer gut zugänglichen Konsole freigestellt. Werden sämtliche Anschlußkontakte, was eine Leiterbahnumlenkung von der einen Pyrex-Glasscheibe auf die andere erforderlich macht, nebeneinander auf einer Pyrex-Glasscheibe angeordnet, so läßt sich, abgesehen von einer wesentlichen Vereinfachung beim späteren Anbonden von Leitungsdrähten, die Länge der Beschleunigungssensoren auf ein Minimum reduzieren. Voraussetzung ist hierfür jedoch, daß bei der Herstellung die Beschleunigungssensoren nicht in eine Richtung weisen sondern wechselständig ausgebildet werden. Hinsichtlich der Anordnung der Anschlußkontakte in nur einer Ebene ist es von besonderer Bedeutung, daß bei dem gewählten Ausführungsbeispiel die Leitungsbildung zwischen der einen Gegenelektrode und dem ihr in einer anderen Ebene zugeordneten Anschlußkontakt über prozeßtypische Maßnahmen erfolgt und letztlich durch das Brechen beim Vereinzeln automatisch isoliert wird.

Im folgenden sei ein Ausführungsbeispiel der Erfindung anhand der beigefügten Zeichnungen näher erläutert. Es zeigen
Fig. 1 eine Draufsicht auf einen Ausschnitt des verbondeten Glas-Silizium-Glas-Schichtpaketes, welches schichtweise aufgebrochen ist,

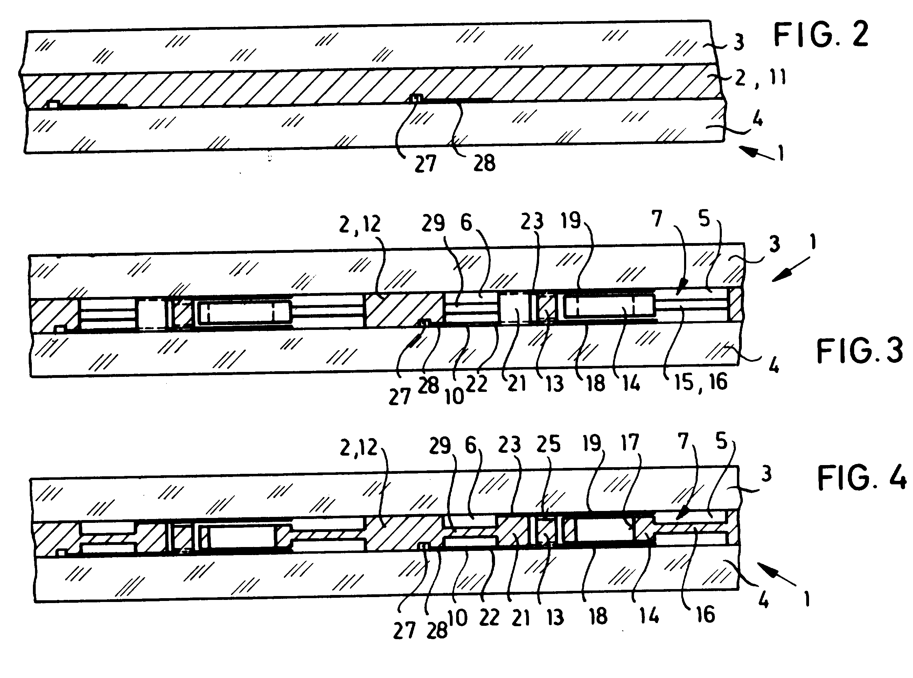

Fig. 2 einen Schnitt gemäß der Schnittlinie A in Fig. 1,
Fig. 3 einen Schnitt gemäß der Schnittlinie B in Fig. 1,
Fig. 4 einen Schnitt gemäß der Schnittlinie C in Fig. 1,
Fig. 5 einen Schnitt gemäß der Schnittlinie D in Fig. 7,
Fig. 6 einen Schnitt gemäß der Schnittlinie E in Fig. 7,
Fig. 7 eine Draufsicht gemäß Fig. 1 mit angebrachten Trennschnitten,
Fig. 8 eine perspektivische Darstellung eines vereinzelten Beschleunigungssensors.

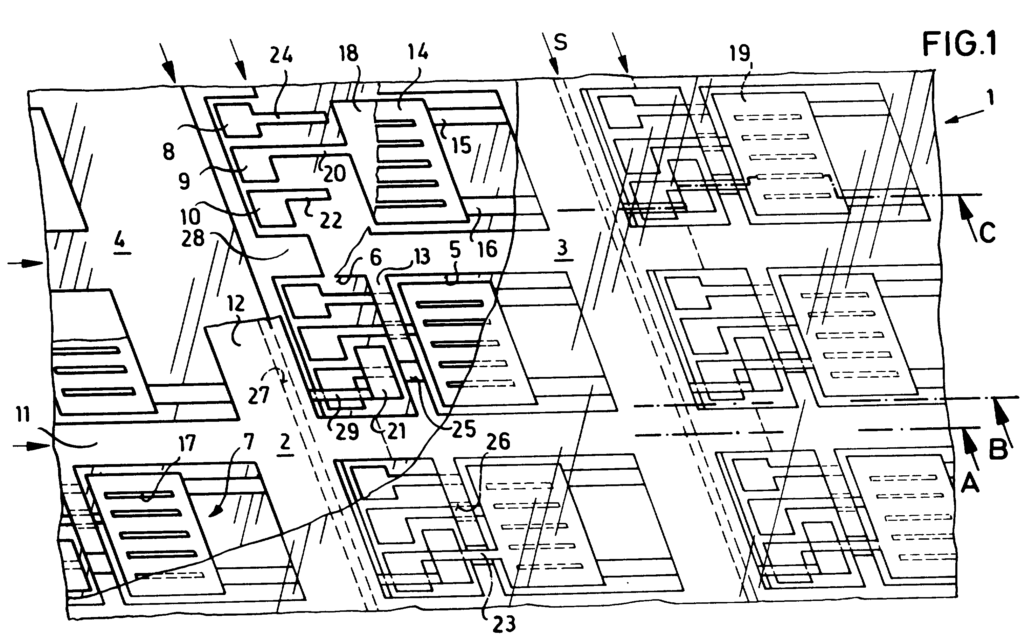

Wie die rautenförmigen Konturen gemäß der Draufsicht Fig. 1 erkennen lassen, werden für die Herstellung der Beschleunigungssensoren 110-orientierte Siliziumscheiben verwendet. Dadurch lassen sich die Vorteile der anisotropen Ätztechnik, nämlich ein erheblich schnelleres Ätzen rechtwinklig zur Schichtfläche, nutzen, d. h. es können besonders enge Spalte geätzt und sowohl die Sensorgrundfläche minimiert als auch eine relativ große Anzahl von die Dämpfung des Biegeschwingers bestimmenden Schlitzen in der Masse des Biegeschwingers angebrac werden. Desgleichen werden die scheibenparallelen Flächen der als Elektrode wirkenden Masse des Biegeschwingers automatisch gleich groß ausgebildet.

Das Schichtpaket 1 ist, wie auch die dreifach überhöhten Schnittdarstellungen zeigen, aus einer leitfähig dotierten Siliziumscheibe 2 und diese beidseitig begrenzenden Pyrex-Glasscheiben 3 und 4 aufgebaut und durch Bonden zusammengefügt. Dabei weist die Siliziumscheibe 2 infolge von Freisparungen 5 und 6 für die Biegeschwinger 7 und die beim Vereinzeln freizustellenden Anschlußkontakte 8, 9 und 10 eine Gitterstruktur auf, so daß die Pyrex-Glasscheiben 3 und 4 lediglich auf Längs- und Querstegen 11 und 12 der gitterförmigen Siliziumscheibe 2 sowie schmalen Trennwänden 13 zwischen den Freisparungen 5 und 6 aufliegen und mit diesen verbondet sind.

Wie aus der Fig. 1 ferner ersichtlich ist, sind die Massen 14 der Biegeschwinger 7 jeweils über zwei federungsfähig ausgebildete Arme 15 und 16 mit den Querstegen 12 verbunden. In den Massen 14 angebrachte Schlitze, von denen einer mit 17 bezeichnet ist, dienen als Luftströmungswege der Optimierung des Frequenzverhaltens, d. h. einer annähernd aperiodischen Dämpfung und einer Verkürzung der Ansprechzeit des jeweiligen Biegeschwingers 7. Sie sind ohne Mehraufwand realisierbar und für die Kondensatorfunktion praktisch ohne Einfluß. Den als Elektroden wirkenden Massen 14 sind vorzugsweise aus Aluminium bestehende Gegenelektroden 18 und 19 zugeordnet, die im wesentlichen flächengleich mit den Massen 14 auf den Pyrex-Glasscheiben 3 und 4 aufgedampft sind. Die elektrischen Verbindungen der Gegenelektroden 18 mit den Anschlußkontakten 9 erfolgen mittels Leiterbahnen 20, die gleichflächig auf der Pyrex-Glasscheibe 4 angebracht sind. Bei der elektrischen Verbindung der Gegenelektroden 19 mit den Anschlußkontakten 10 ist eine Umlenkung von einer Ebene in eine andere Ebene erforderlich. Hierzu dienen Siliziumblöcke 21, welche mit den Pyrex-Glasscheiben 3 und 4 verbondet sind und dabei Leiterbahnen 22 und 23 durch Druckkontaktierung koppeln. Die Anschlußkontakte 8 bzw. die von ihnen ausgehenden Leiterbahnen 24 sind ebenfalls druckkontaktiert, und zwar mit der Siliziumscheibe 2, d. h. sie befinden sich zwischen den Trennwänden 13 und der Glasscheibe 4. Demgegenüber dienen in den Trennwänden 13 ausgebildete Aussparungen 25 und 26 der Isolation der Leiterbahnen 20 und 23 gegenüber der Siliziumscheibe 2.

In den Querstegen 12 der Siliziumscheibe 2 sind stegparallel Nute 27 ausgebildet, die einerseits, ohne daß die Siliziumscheibe 2 beim Vereinzeln mit einer Trennscheibe angeschnitten wird, dem vollständigen Freischneiden der Glasscheibe 4 dienen, andererseits den Vorteil einer sicheren und toleranzausgleichenden Trennung zwischen den Bondflächen der Querstege 12 und das Bonden verhindernden Zwischenschichten 28 bieten. Vorzugsweise greifen die Zwischenschichten 28, die gleichzeitig mit dem Aufbringen der Anschlußkontakte 8, 9 und , 10, der Leiterbahnen 20, 22 und 24 und der Gegenelektroden 18 auf der Glasscheibe 4 aufgebracht werden und im gewählten Ausführungsbeispiel Aluminium darstellen, auch auf die Längsstege 11 über, so daß innerhalb des Glas-Silizium-Glas-Schichtpaketes die Anschlußkontakte 8, 9 und 10 eines jeden Beschleunigungssensors von einem zwischen der betreffenden Glasscheibe und der Siliziumscheibe nicht verbondeten, U-förmigen Bereich umgeben sind.

Der Vollständigkeit halber sei erwähnt, daß die Siliziumblöcke 21 über in geeigneter Weise freigeätzte Arme 29 mit den Querstegen 12 verbunden sind. Diese Verbindung muß derart gestaltet sein, daß sie beim Vereinzeln der Beschleunigungssensoren bricht und somit die Siliziumblöcke 21 ausschließlich Leitungselemente zwischen den Gegenelektroden 19 und den Anschlußkontakten 10 darstellen.

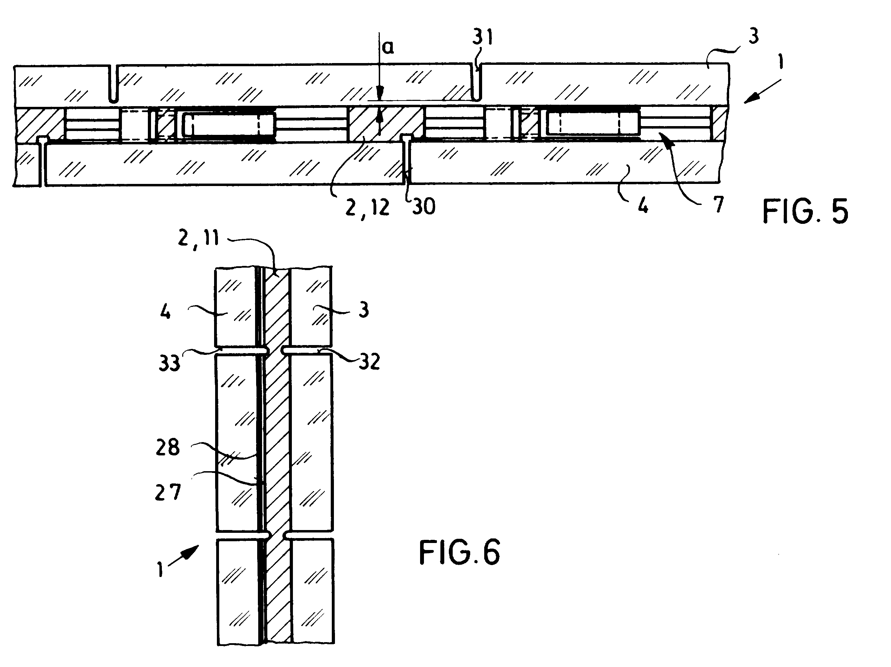

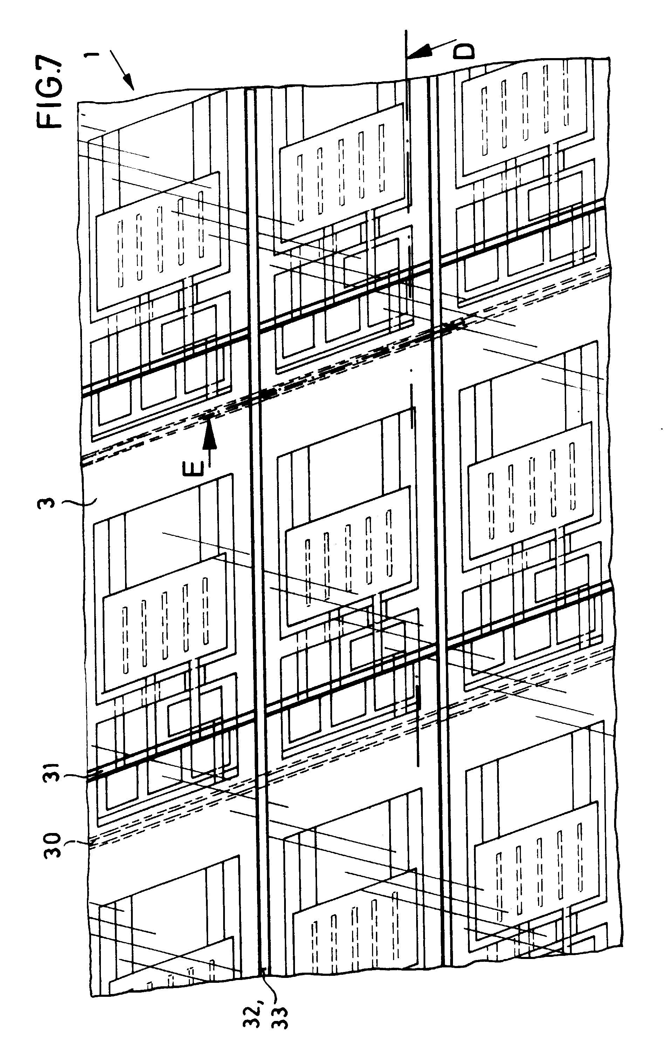

Mit den in der Fig. 1 dargestellten Pfeilen - einer ist mit S bezeichnet - sollen die Ebenen markiert sein, in denen die Trennschnitte zum Vereinzeln der Beschleunigungssensoren angebracht werden. In der Draufsicht Fig. 7 sowie der Schnittdarstellung Fig. 5 sind mit 30 Trennschnitte bezeichnet, mit welchen die Glasscheibe 4, wie bereits beschrieben, vollständig durchschnitten ist. Im Gegensatz hierzu ist die gegenüberliegende Glasscheibe 3 durch parallel zu den Trennschnitten 30 verlaufende Trennschnitte 31 bis auf eine Sollbruchstärke a eingeschnitten. Die Fig. 6, eine Schnittdarstellung gemäß der Schnittlinie E in Fig. 7, zeigt quer zu den Trennschnitten 30 und 31 verlaufende und in die Längsstege 11 eingreifende Trennschnitte 32 und 33.

Die Fig. 5 und 6 machen deutlich, daß beim Einschneiden keine Verschmutzung der Beschleunigungssensoren erfolgen kann. Erst beim nachfolgenden Abdrücken des Schichtpaketes auf einer elastischen Unterlage, beispielsweise mittels einer kreuzweise bewegten Walze, was ein Zerbrechen des Schichtpaketes 1 und dabei ein Vereinzeln der Beschleunigungssensoren zur Folge hat, werden die Anschlußkontakte des jeweiligen Beschleunigungssensors freigelegt und die elektrische Verbindung zwischen dem Anschlußkontakt 10 und der Gegenelektrode 19 isoliert, aber auch die Freisparung 5, in welcher sich der Biegeschwinger 7 befindet, über die Ausparungen 25 und 26 nach außen geöffnet.

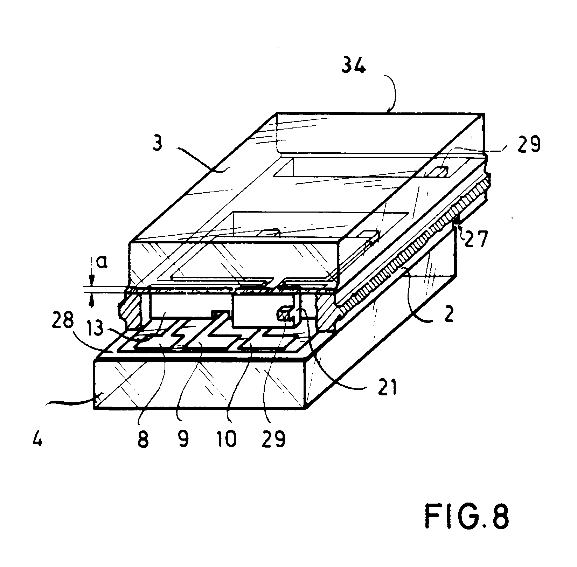

Die ergänzende Fig. 8 zeigt den vereinzelten Beschleunigungssensor. Aus dieser Figur ist insbesondere die Bedeutung der als Sperrschicht wirkenden Zwischenschicht im Zusammenwirken mit der Nut 27 und dem vollständigen Durchtrennen der Glasscheibe 4 zu erkennen. Ein leichtes Verbiegen des Schichtpaketes genügt, um ein Brechen an den in Fig. 8 schraffiert gezeichneten Sollbruchstellen zu erzielen und gleichzeitig die Anschlußkontakte 8, 9 und 10 gut zugänglich freizustellen.

Bei der beschriebenen Anordnung, bei der die Sensorstrukturen in eine Richtung weisen, entsteht beim Vereinzeln kein Abfall. Dafür weist aber jeder Beschleunigungssensor einen Ansatz 34 auf, der ohne Funktion ist, den Beschleunigungssensor somit unnötig verlängert. Dieser Nachteil läßt sich vermeiden, wenn die Sensorstrukturen sozusagen wechselständig einander gegenüberstehen. Allerdings muß dann in Kauf genommen werden, daß beim Vereinzeln zwischen zwei mit den Anschlußkontakten gegeneinander gewandten Beschleunigungssensoren ein Abfallstück entsteht. Denkbar ist ferner, daß die Anschlußkontakte der Gegenelektroden jeweils in der gleichen Ebene ausgebildet sind. In diesem Falle wäre, wenn das gleiche Vereinzelungsverfahren Anwendung finden soll, eine wechselständige Anordnung der Sensorstrukturen erforderlich, und es würde, wie im vorstehend beschriebenen Beispiel, beim Vereinzeln ein Abfallstück entstehen. Diese Lösung ist jedoch bezüglich des Anbondens der Leitungsdrähte weniger vorteilhaft.

## Patentansprüche

1. Verfahren zum Vereinzeln von als Differentialkondensatoren ausgebildeten Beschleunigungssensoren aus einem Glas-Silizium-Glas-Schichtpaket, bei welchem die scheibenförmige Siliziumschicht eine Gitterstruktur mit freigesparten Biegeschwingern aufweist und die mit der Siliziumscheibe verbondeten Glasscheiben den plattenförmigen Massen der Biegeschwinger zugewandte, im wesentlichen flächengleiche Metallschichten tragen, welche mit auf einer Glasscheibe aufgebrachten Anschlußkontakten elektrisch leitend verbunden sind,
dadurch gekeinnzeichnet,
daß das Glas-Silizium-Glas-Schichtpaket (1) kreuzweise eingeschnitten wird, wobei zum Freilegen der Anschlußkontakte (8, 9, 10) das Einschneiden wenigstens in der einen Richtung gegenseitig und in zwei parallelen Ebenen erfolgt und zwischen den als Auflage für die Glasscheiben (3, 4) dienenden Stegen (11, 12) der gitterförmigen Siliziumscheibe (2) und der Anschlußkontakte (8, 9, 10) tragenden Glasscheibe (4) vor dem Bonden wenigstens in einem Randbereich zwischen der äußeren Schnittebene (S) zum Freilegen der Anschlußkontakte (8, 9, 10) eines Beschleunigungssensors und den Anschlußkontakten (8, 9,10) eine eine Bondverbindung verhindernde Zwischenschicht (28) eingerichtet wird und
daß das Schichtpaket (1) an den durch Einschneiden geschaffenen Sollbruchstellen gebrochen wird.

2. Verfahren nach Anspruch 1,
dadurch gekennzeichnet,
daß die Zwischenschicht (28) die Anschlußkontakte U-förmig umgreifend zwischen den dem Freilegen der Anschlußkontakte (8, 9, 10) dienenden Ebenen (5) der Trennschnitte (30, 31) eingerichtet wird.

3. Verfahren nach Anspruch 1,
dadurch gekennzeichnet,
daß das Brechen des Schichtpaketes (1) durch Andrücken an eine elastische Unterlage erfolgt.

4. Verfahren nach Anspruch 1,
dadurch gekennzeichnet,
daß das Brechen des Schichtpaketes (1) durch Andrücken an eine gewölbte Unterlage erfolgt.

5. Verfahren nach Anspruch 1,
dadurch gekennzeichnet,
daß die Zwischenschicht (28) eine Metallschicht darstellt, welche gleichzeitig mit dem Metallisieren der die Anschlußkontakte (8, 9, 10) tragenden Glasscheibe (4) aufgebracht wird.

6. Verfahren nach Anspruch 1,
dadurch gekennzeichnet,
daß während des Ätzens der Siliziumscheibe (2) in der jeweils äußeren Schnittebene (S) liegende, den Kontakt mit der jeweiligen Zwischenschicht (28) begrenzende Nute (27) ausgebildet werden.

7. Verfahren nach Anspruch 1,
dadurch gekennzeichnet,
daß zum Freilegen der Anschlußkontakte (8, 9, 10) die eine Glasscheibe (4) durchschnitten und die gegenüberliegende Glasscheibe (3) bis auf eine Sollbruchstärke (a) eingeschnitten wird.

8. Verfahren nach Anspruch 1,
dadurch gekennzeichnet,
daß bei einer Anordnung der Anschlußkontakte (8, 9, 10) auf ein und derselben Glasscheibe (4) für die jeweilige elektrische Verbindung zwischen dem einen Anschlußkontakt (10) und der nicht flächengleichen Gegenelektrode (19) eines Beschleunigungssensors ein Siliziumblock (21) vorgesehen ist, welcher unter Zwischenlage von von der Gegenelektrode (19) und dem Anschlußkontakt (10) ausgehenden Leiterbahnen (22, 23) beim Verbonden des Schichtpaktes (1) mit den Glasscheiben (3, 4) verbondet wird.

9. Verfahren nach Anspruch 1 und 8,
dadurch gekennzeichnet,
daß die mechanische Verbindung (29) des Siliziumblocks (21) mit der Siliziumscheibe (2) derart ausgebildet ist, daß sie beim Vereinzeln der Beschleunigungssensoren bricht.

## Claims

1. A process for separating acceleration sensors which are constructed as differential capacitors from a glass/silicon/glass laminated stack, in which the wafer-shaped silicon layer has a grid structure with flexural resonators which have been cut round and the glass wafers bonded to the silicon wafer carry metal layers which face the plate-shaped masses of the flexural resonators, are substantially equal in area and are connected in electrically conductive manner to terminal contacts mounted on a glass wafer, characterized in that the glass/silicon/glass laminated stack (1) is incised crosswise, during which the incising takes place at least in the one direction from both sides and in two parallel planes in order to expose the terminal contacts (8, 9, 10) and, between the webs (11, 12), serving as a support for the glass wafers (3, 4), of the grid-shaped silicon wafer (2) and the glass wafer (4) carrying terminal contacts (8, 9, 10) there is made, before bonding, at least in one edge region between the outer cutting plane (S) for exposing the terminal contacts (8, 9, 10) of an acceleration sensor and the terminal contacts (8, 9, 10), an intermediate layer (28) which prevents a bonding connection, and in that the laminated stack (1) is broken at the predetermined break points formed by the incisions.

2. A process according to Claim 1, characterized in that the intermediate layer (28) is positioned, surrounding the terminal contacts in a U shape, between the planes (5) of the parting cuts (30, 31) which serve to expose the terminal contacts (8, 9, 10).

3. A process according to Claim 1, characterized in that the laminated stack (1) is broken by being pressed against a resilient support.

4. A process according to Claim 1, characterized in that the laminated stack (1) is broken by being pressed against a convex support.

5. A process according to Claim 1, characterized in that the intermediate layer (28) is a metal layer which is applied at the same time as the metallization of the glass wafer (4) carrying the terminal contacts (8, 9, 10).

6. A process according to Claim 1, characterized in that during etching of the silicon wafer (2) grooves (27) are constructed lying in the respectively outer cutting plane (S) and delimiting contact with the respective intermediate layer (28).

7. A process according to Claim 1, characterized in that to expose the terminal contacts (8, 9, 10) the one glass wafer (4) is cut through and the opposing glass wafer (3) is incised, leaving a predetermined break thickness (a).

8. A process according to Claim 1, characterized in that, in an arrangement of the terminal contacts (8, 9, 10) on one and the same glass wafer (4), for the respective electrical connection between the one terminal contact (10) and the counter-electrode (19) not equal in area of an acceleration sensor, there is provided a silicon block (21) which is bonded to the glass wafers (3, 4) on bonding the laminated stack (1), with the interposition of conductor tracks (22, 23) emerging from the counter-electrode (19) and the terminal contact (10).

9. A process according to Claim 1 and 8, characterized in that the mechanical connection (29) of the silicon block (21) to the silicon wafer (2) is constructed such that it breaks when the acceleration sensors are separated.

## Revendications

1. Procédé pour le démembrement de détecteurs d'accélération réalisés sous forme de condensateurs différentiels constitués d'un empilage de couches de verre-silicium-verre, dans lequel la couche de silicium en forme de tranche présente une structure réticulaire avec des résonateurs de flexions évidés et les plaques de verre, reliées par bonding à la tranche de silicium, portent des couches métalliques dirigées vers les masses en forme de plaque des résonateurs de flexions et présentant des surfaces pour l'essentiel identiques, qui sont reliées, par conduction électrique, à des contacts de raccordement disposés sur une plaque de verre,
caractérisé par le fait
que l'empilage de couches de verre-silicium-verre (1) sera incisé en croix, l'incision pour le dégagement des contacts de raccordement (8, 9, 10) se faisant, au moins dans l'une des directions, en opposition et en deux plans parallèles et qu'une couche intermédiaire (28) empêchant le bonding sera arrangée entre les traverses (11, 12) de la tranche de silicium réticulaire (2) servant de support aux plaques de verre (3, 4) et la plaque de verre (4) portant les contacts de raccordement (8, 9, 10), avant le bonding, au moins dans une zone marginale entre le plan de coupe extérieur (S) pour le dégagement des contacts de raccordement (8, 9, 10) d'un détecteur d'accélération et lesdits contacts de raccordement (8, 9, 10), et que l'empilage de couches (1) sera rompu aux endroits de rupture prévus créés par incision.

2. Procédé selon la revendication 1,
caractérisé par le fait
que la couche intermédiaire (28), entourant les contacts de raccordement en formant un U, sera arrangée entre les plans (5) des coupes de séparation (30, 31) servant au dégagement desdits contacts de raccordement (8, 9, 10).

3. Procédé selon la revendication 1,
caractérisé par le fait
que le bris de l'empilage de couches (1) se fait en pressant celui-ci contre un support élastique.

4. Procédé selon la revendication 1,
caractérisé par le fait
que le bris de l'empilage de couches (1) se fait en pressant celui-ci contre un support bombé.

5. Procédé selon la revendication 1,
caractérisé par le fait
que la couche intermédiaire (28) représente une couche métallique qui sera apportée simultanément avec la métallisation de la plaque de verre (4) portant les contacts de raccordement (8, 9, 10).

6. Procédé selon la revendication 1,
caractérisé par le fait
que, pendant la gravure de la tranche de silicium (2), sont réalisées des rainures (27) situées dans le plan de coupe respectivement externe (S) et limitant le contact avec la couche intermédiaire (28) respective.

7. Procédé selon la revendication 1,
caractérisé par le fait
que, pour le dégagement des contacts de raccordement (8, 9, 10), l'une des plaques de verre (4) sera tranchée et la plaque de verre située à l'opposé (3) sera incisé jusqu'à une épaisseur de rupture (a) prévue.

8. Procédé selon la revendication 1,
caractérisé par le fait
que, avec un arrangement des contacts de raccordement (8, 9, 10) sur une seule et même plaque de verre (4) pour la liaison électrique respective entre l'un des contacts de raccordement (10) et la contre-électrode (19) ne présentant pas une surface identique d'un détecteur d'accélération, il est prévu un bloc de silicium (21) qui est relié, lors du bonding de l'empilage de couches (1), par bonding aux plaques de verre (3, 4) avec intercalation de pistes conductrices (22, 23) émanant de ladite contre-électrode (19) et dudit contact de raccordement (10).

9. Procédé selon l'une quelconque des revendications 1 et 8,
caractérisé par le fait
que l'assemblage mécanique (29) du bloc de silicium (21) avec la tranche de silicium (2) est réalisé de telle sorte qu'il se rompt lors du démembrement des détecteurs d'accélération.
